# EUROPEAN PATENT APPLICATION

(11) **EP 2 000 812 A1**
(43) Date of publication of application: **10.12.2008**
(21) Application number: 07290695.1
(22) Date of filing: 05.06.2007
(51) Int. Cl.: G01R 31/3185, G01R 31/319, G01R 31/3183

(54) **Testable integrated circuit die and integrated circuit package**

(71) Applicant: NXP B.V., 5656 AG Eindhoven (NL)
(72) Inventor: The designation of the inventor has not yet been filed
(74) Representative: White, Andrew Gordon

(57) **Abstract**

An integrated circuit die (100) is disclosed that comprises a functional block (110) and a test module for testing the functional block. The test module comprises test pattern decompression logic (120) for receiving a compressed test pattern and providing the functional block (110) with the decompressed test pattern and test result compression logic (130) for compressing a test result received from the functional block (110). The integrated circuit die (100) further comprises a test access port (TAP) (140) such as an IEEE 1149.1 compliant TAP. The test pattern decompression logic (120) is coupled to the test data input of the TAP (140) and the result compression logic (130) is coupled to test data output of the TAP (140) to facilitate shifting in/out of compressed test data under control of the test clock. The TAP instruction register (150) is responsive to a dedicated instruction for activating the test module. Consequently, an on-chip test compression arrangement is provided that can be fully controlled through the TAP (140).

## Description

The present invention relates to an integrated circuit (IC) die comprising a functional block having a plurality of inputs and a plurality of outputs and a test module for testing the functional block in a test mode, the test module comprising test pattern decompression logic comprising a clock signal input, an input for receiving a compressed test pattern and a plurality of outputs for providing the plurality of inputs of the functional block with the decompressed test pattern and test result compression logic comprising a clock signal input, a plurality of inputs for receiving a test result from the plurality of outputs of the functional block and an output for making the test result available in a compressed form.

The present invention further relates to an IC package comprising such a die.

The present invention yet further relates to automated test equipment for testing such an IC die.

Advances in semiconductor technology have facilitated the manufacturing of complex ICs, which may contain many millions of components organized in a multitude of functional blocks such that the IC can harbour a multitude of different functionalities. An example of such an IC is a system-on-chip (SoC). To ensure their correct operation, ICs need to be tested prior to their release to a customer. Due to the large number of components and the diversity of the functionality of these complex lCs, a large amount of test data is required to extensively test such an IC, which can result in significant test times, which adds to the cost of the IC. The significant test times are predominantly caused by the relatively slow communication of test patterns and test results between the IC and the test equipment.

A reduction in such test times is achieved by the IC die of the opening paragraph, which facilitates the communication of test patterns and test results between the IC die and the test equipment in a compressed form. An example of such an IC comprising such a die can be found in US patent application US 2003/015521 A1.

Typically, the communication of the compressed test data to and from the IC die is realized using dedicated IC pins. However, the packaging of an IC die may cause test pattern decompression logic and test result compression logic to become inaccessible. This may for instance be the case if the die is integrated in a multi-chip module such as a system-in-package (SiP).

The present invention seeks to provide an IC die according to the opening paragraph in which the test pattern decompression logic and test result compression logic can be utilized more robustly.

The present invention further seeks to provide an IC package comprising such an IC.

According to an aspect of the present invention, the IC die of the opening paragraph further comprises a test access port (TAP) comprising a test data input (TDI) coupled to the test pattern decompression logic input; a test data output (TDO) coupled to the test result compression logic output; a test clock input (TCK) coupled to the respective clock inputs of the test pattern decompression logic and the test result compression logic; a test mode select input (TMS) for receiving a test mode select signal; and an instruction register (IR) coupled between the test data input and the compression test module for activating the test module in response to a dedicated instruction received from the test data input.

The present invention is based on the realization that most packaged lCs comprise a TAP such as an IEEE 1149.1 (Boundary Scan Test) compliant TAP. According to the present invention, the functionality of the TAP has been extended by adding a dedicated instruction for activating the test module to the instruction set recognized by the decoding logic of the instruction register, and by connecting the compression and compression logic to TDI and TDO respectively. Consequently, the testing of the functional block by means of the test module can be completely controlled through the TAP.

The TAP has a TAP controller, which is a state machine that steps through a number of predefined states in response to the test mode select signal. Each state triggers the generation of a unique set of control signals that control the various shift registers coupled to the TAP. According to the present invention, the TAP controller is configured to enable data communication between the test data input and the input of the test pattern decompression logic and to enable data communication between the test result compression logic output and the test data output in a first state; and to enable data communication between the test module and the functional block in a second state. This way, potential data conflicts between the various stages of the functional block testing procedure can be avoided.

Preferably, the IC die further comprises masking logic coupled between the functional block and the test result compression logic, the masking logic having an input coupled to the test data input for receiving masking configuration data, the test access port controller being configured to enable data communication between the test data input and the masking logic input in a fourth state. The masking logic ensures that in case the functional block produces indeterminate or undefined outputs, i.e. so-called X outputs, these outputs are set to a defined value to ensure that the X outputs do not corrupt the test result compression logic.

The IC die may comprise first clock gating logic for gating the test clock signal to the test pattern decompression logic; and second clock gating logic for gating the test clock signal to the test result compression logic. This has the advantage that different parts of the test arrangement of the IC die can be updated under control of the test clock signal in different clock cycles, thus improving the flexibility of the test arrangement.

Preferably, the IC die comprises a first multiplexer having an output and a plurality of inputs, each coupled to a respective output from the plurality of outputs of the functional block such that the test result compression logic is bypassed; and a second multiplexer having a first input coupled to the output of the test result compression logic, a second input coupled to the output of the first multiplexer and an output coupled to the test data output.

This facilitates the evaluation of test results from selected outputs of the functional block via the test data output, which increases the probability to localize faults in the functional block for failure analysis purposes, and increases the number of faults of the functional block that can be detected.

According to a further aspect of the present invention, an integrated circuit package is provided that comprises an IC die of the present invention, wherein the test data input, the test data output, the test mode select input and the test clock input are externally accessible. Such a package, which may comprise multiple IC dies, benefits from having an IC die that can be tested efficiently by virtue of the aforementioned externally accessible pins.

According to a yet further aspect of the present invention, there is provided automated test equipment (ATE) for testing an integrated circuit die according to the present invention, the automated test equipment comprising means for communicating data to the test data input, said means being configured to communicate the dedicated instruction for activating the test module and to communicate a compressed test pattern for the test pattern decompression logic; clock signal generation means for providing the test clock input with the test clock signal; test mode selection means for providing the test mode select input with the test mode select signal; and data reception means for receiving data from the test data output.

This enables the ATE of the present invention to activate the test module of the IC die of the present invention.

The invention is described in more detail and by way of non-limiting examples with reference to the accompanying drawings, wherein:
Fig. 1 depicts an embodiment of an IC die according to the present invention;
Fig. 2 depicts the states of a boundary scan compliant TAP controller;
Fig. 3 depicts the time-dependent behaviour of the signals involved in a test mode of the functional module of an IC die of the present invention;
Fig. 4 depicts an embodiment of gating logic of the IC die of the present invention;
Fig. 5 depicts an alternative embodiment of gating logic of the IC die of the present invention;
Fig. 6 depicts another embodiment of an IC die according to the present invention; and
Fig. 7 depicts the time-dependent behaviour of the signals involved in another test mode of the functional module of an IC die of the present invention.

It should be understood that the Figures are merely schematic and are not drawn to scale. It should also be understood that the same reference numerals are used throughout the Figures to indicate the same or similar parts.

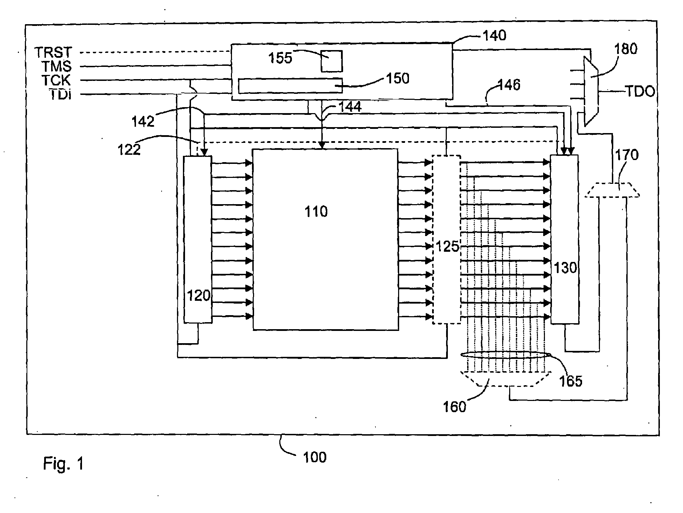

The IC die 100 in Fig. 1 has a functional block 110 that requires testing. The functional block 110 may be any, block that processes data in a functional mode of the IC die 100. The functional block 110 typically comprises a plurality of internal scan chains (not shown) between its inputs and its outputs. To facilitate the testing of the functional block 110, the IC die 100 comprises a test module including test pattern decompression logic 120 and test result compression logic 130. The test pattern decompression logic 120 and the test result compression logic 130 are known per se, and will not be described in detail for that reason. For instance, the test pattern decompression logic 120 may be any known decompression logic such as a linear feedback shift register (LFSR), while the test result compression logic 130 may be any known compression logic such as a multiple input shift register (MISR) for calculating a signature from the data received from the functional block scan chain outputs.

The IC die 100 further comprises a TAP 140. Preferably, the TAP 140 is IEEE 1149.1 compliant, although this is not necessary. For the sake of brevity, the TAP 140 will be assumed to be IEEE 1149.1 compliant in the remainder of this application. A detailed description of the IEEE 1149.1 standard including a detailed description of TAP 140 can be found in: 'IEEE Standard Test Access Port and Boundary-Scan Architecture', version 1149.1 - 2001, IEEE, New York, ISBN 0-7382-2944-5. In addition to TDI, TDO, TMS and TCK, the TAP 140 in Fig. 1 also includes the test reset input (TRST). It will be appreciated that this input is optional, in accordance with the IEEE 1149.1 standard. The TAP 140 comprises, amongst other mandatory functionality (not shown), an instruction register 150 coupled to TDI and a TAP controller 155 coupled to TMS and TCK.

In accordance with the present invention, TDI is coupled to an input for receiving a compressed test pattern of the test pattern decompression logic 120. The compressed test pattern may for instance comprise a seed for a LFSR. TDO is coupled to an output of the test result compression logic 130 to facilitate external observation of the compressed test result via TDO. The TAP 140 typically comprises a multiplexer (MUX) 180 coupled between the respective outputs of the various shift registers, including the test result compression logic 130, that can be activated by instructions fed into the instruction register 150. The test pattern decompression logic 120 and the test result compression logic 130 are responsive to a test clock provided via TCK during the shifting in/out of the compressed test patterns and test results. A path 122 may connect the decompression logic 120 and the compression logic 130 to facilitate testing of the path between TDI and TDO.

In case some decompressed test patterns provided to functional block 110 by decompression logic 120 cause the functional block 110 to produce undefined X values on at least some of its outputs, the test module may further comprise X-masking logic 125 coupled between the functional block 110 and the test result compression logic 130 for ensuring that the undefined X-values on the outputs of the functional block 110 are converted into defined values. Because many X-masking logic arrangements are well-known in the art, the operation of X-masking logic 125 will not be further explained. According to the present invention, the masking logic 125 has an input coupled to TDI for receiving masking information. The masking information may comprise a mask_all signal for masking all outputs of the functional block 110 in case some of its outputs exhibit X-values. This has the advantage that the masking information can be applied to the masking logic 125 in a single clock cycle.

Alternatively, the masking information may comprise a mask for masking only those outputs of the functional block 110 that exhibit X-values. This has the advantage that a better test resolution is obtained. In this embodiment, the masking logic 125 may be responsive to the test clock provided via TCK for controlling the shifting in of the mask.

Optionally, the IC die may comprise a MUX 160 which receives branches 165 of the individual outputs of the functional block 110 on its inputs. The output of MUX 160 is coupled to TDO via 2-input MUX 170, which receives the output of the test result compression logic 130 on its other input. The combination of MUX 160 and MUX 170 facilitates bypassing the test result compression logic 130 so that individual outputs of the functional block 110 can be evaluated via TDO in uncompressed form. The individual output of the functional output 110 may be selected by loading an appropriate bit pattern into a selected shift register of the TAP 140, to which MUX 160 is responsive.

The IC die 100 may be packaged into a stand-alone device, or may become a part of a multi-die package, such as a SiP.

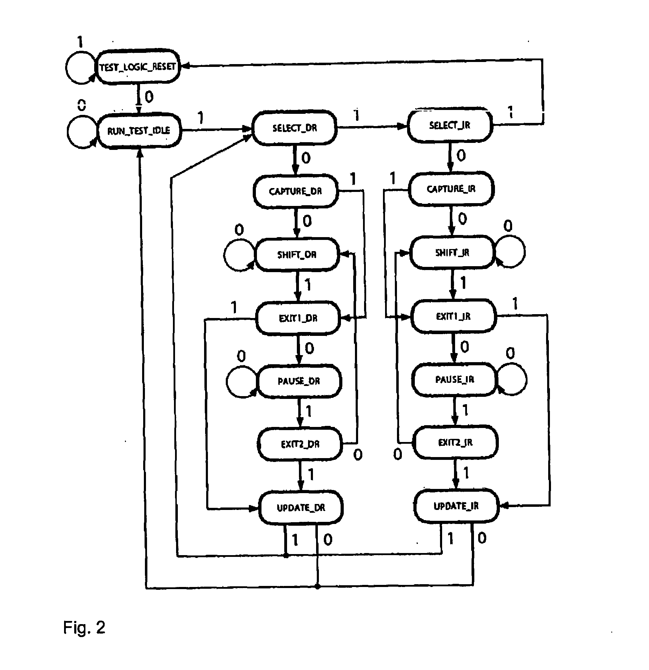

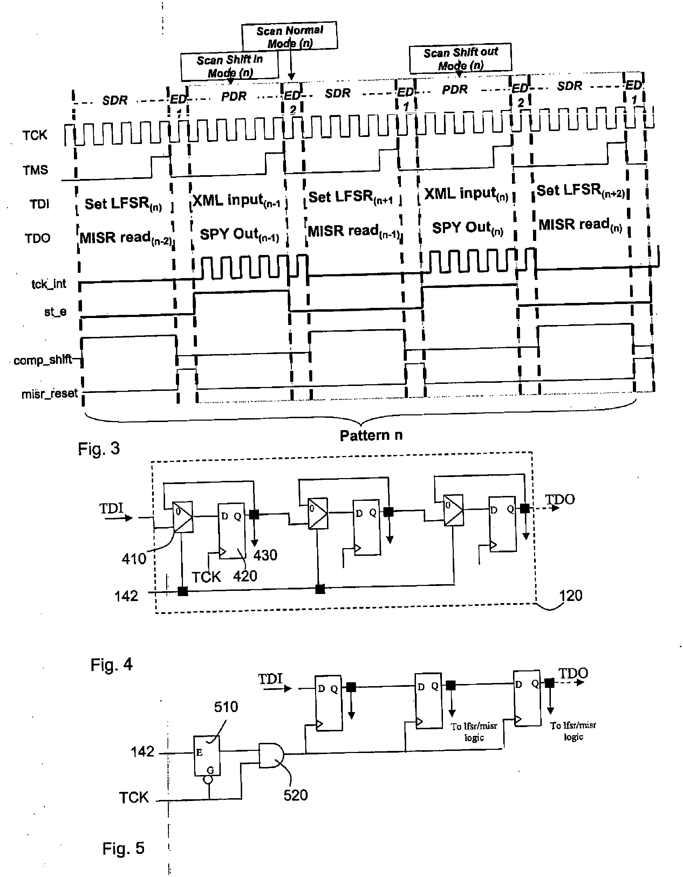

A control mechanism of the test module according to the present invention is described in more detail with the aid of Fig. 2 and Fig. 3. The TAP controller state machine shown in Fig. 2 is described in detail in the aforementioned IEEE 1149.1 standard document. This detailed description is also applicable to the TAP controller 155, because the TAP controller 155 implements the same state machine.

Upon initialization of the TAP 140, a dedication instruction for activating the test module of the functional block 110 is loaded into the instruction register 150 in accordance with the IEEE 1149.1 standard. This dedicated instruction enables access to the various parts of the test module via TDI/TDO, i.e. test pattern decompression logic 120, test result compression logic 130 and masking logic 125 if present. In addition, the following states of the TAP controller 155 (Table I) may be configured to control access to and initialization of the test module as well as testing of the functional block 110:

**Table I**

| TAP controller state | TAP connection | Purpose |
|---|---|---|
| SH1FT_DR (SDR) | TDI | Load compressed test pattern into test pattern decompression logic 120 |
| | | |
| | TDO | Read compressed test result from test result compression logic 130 |
| EXIT1_DR (ED1) | | Reset the test result compression logic 130 |
| PAUSE_DR (PDR) | TDI | Provide masking configuration data to the masking logic 125 |
| | | |
| | TDO | Read uncompressed selected output of functional block 110 |
| Exit2_DR (ED2) | | Enable communication between functional block 110 and test module and test functional block 110 |
| Other | All | As defined in IEEE 1149.1 |

The chronological order of the various steps is depicted in Fig. 3. In Fig. 3, the n^{th} test cycle of the functional block 110 is highlighted. The cycle starts in SDR, in which the TAP controller 155 releases the test clock to the test pattern decompression logic 120 and the test result compression logic 130 by providing a logic high comp_shift signal on signal line 142. Examples of gating circuitry for selectively releasing the test clock for the test pattern decompression logic 120 and the test result compression logic 130 are shown in Figs 4 and 5. In Fig. 4, test pattern decompression logic 120 is shown as a LFSR having a multiplexer 410 coupled to the input of each shift register flip-flop 420. Outputs 430 are the outputs to functional block 110. The signal presented on TDI is only forwarded to the flip-flop 420 if the comp_shift signal on signal line 142 is high. If this signal is low, the data in the flip-flops coupled to the output of multiplexer 410 will be looped back to the multiplexer 410 such 5, the clock signal terminals of the flip-flops 420 are coupled to an output of an AND gate 520, which has TCK and an output of a latch 510 as its inputs. The input of latch 510 is coupled to signal line 142. Consequently, the test clock will only be forwarded to flip-flops 420 if the comp_shift signal of signal line 142 is high. It will be understood that other gating arrangements are equally feasible.

In case a test clock controlled masking logic 125 is available, the TAP controller 155 simultaneously gates the test clock to the masking logic 125 in state SDR. This is to avoid corruption of data in the test clock controlled masking logic 125. Now, under control of the test clock, a compressed n^{th} test pattern is shifted into the test pattern decompression logic 120 via TDI (Set LFSR₍ₙ₎) and a compressed (n-2)^{th} test result is shifted out of the test result compression logic 130 via TDO (MISR read₍ₙ₋₂₎). It will be understood that at this point, the (n-1)^{th} test result is still in the process of being generated by the functional block 110,

Next, the TAP controller 155 steps to ED1, in which the test clock to the test pattern decompression logic 120 and the test result compression logic 130 is gated by providing a logic low comp_shift signal on signal line 142. This ensures that the data in the test pattern decompression logic 120 and the test result compression logic 130 cannot be corrupted. A reset signal (misr_reset) is provided on signal line 146 to reset test result compression logic 130 to ensure that the test result compression logic 130 is in an initial, well-defined state prior to capturing test result data from the functional block 110.

Next, the TAP controller 155 steps to PDR. In this state, the internal test clock tck_int of the functional block 110 is released, and the internal scan chains of the functional block 110 are switched to a shift mode by the provision of an enable signal st_e via signal line 144. The clock signal received on input TCK is used as the internal test clock, which is provided to the functional block 110 via gating logic (not shown) to facilitate gating of the internal test clock in selected states of the TAP controller 155. The test result compression logic 130 receives the test responses to the (n-1)^{th} test pattern and calculates the compressed (n-1)*^{th}* test result. This state also allows direct observation of an compressed (n-1)^{th} test result. This state also allows direct observation of an uncompressed test result on TDO via MUX 160 and MUX 170. At the same time, if applicable, a mask_all signal is provided to the masking logic 125 via TDI during selected test clock cycles of the shift mode. In case the masking logic 125 comprises a linear feedback shift register, which for instance is the case if the masking logic 125 is configured to apply a specific multi-bit mask instead of a global mask in response to a mask_all signal, the test data input is used to reseed the linear feedback shift register in every clock cycle such that the masking logic 125 comprises the appropriate mask in each of said clock cycles.

Finally, in state ED2, the functional block 110 is tested for stuck_at faults. Table II gives an overview of the various signals generated in the various states of the TAP controller 155 in response to the dedicated instruction SIP_TEST.

**Table II INSTRUCTION SIP_TEST**

| TAP CONTROLLER STATES | TAP RESET | 142 | 146 | TCK release | tck_int release | 144 |
|---|---|---|---|---|---|---|
| TLR | 1 | 0 | 0 | 1 | 1 | 0 |
| RTI | 0 | 0 | 0 | 1 | 1 | 0 |
| SDS | 0 | 0 | 0 | 1 | 1 | 0 |
| CDR | 0 | 0 | 0 | 1 | 1 | 0 |
| SDR | 0 | 1 | 0 | 1 | 0 | 0 |
| E1D | 0 | 0 | 1 | 0 | 0 | 0 |
| PDR | 0 | 0 | 0 | 1 | 1 | 1 |
| E2D | 0 | 0 | 0 | 1 | 1 | 0 |
| UDR | 0 | 0 | 0 | 1 | 1 | 0 |
| SIS | 0 | 0 | 0 | 1 | 1 | 0 |
| CIR | 0 | 0 | 0 | 1 | 1 | 0 |
| SIR | 0 | 0 | 0 | 1 | 1 | 0 |
| E1I | 0 | 0 | 0 | 1 | 1 | 0 |
| PIR | 0 | 0 | 0 | 1 | 1 | 0 |
| E21 | 0 | 0 | 0 | 1 | 1 | 0 |
| UIR | 0 | 0 | 0 | 1 | 1 | 0 |

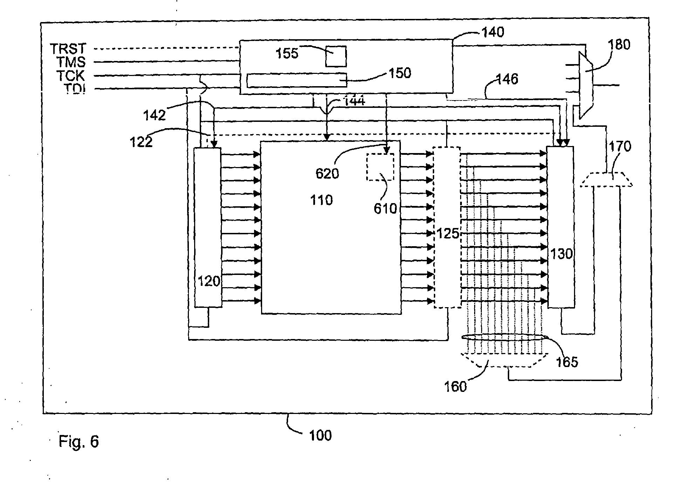

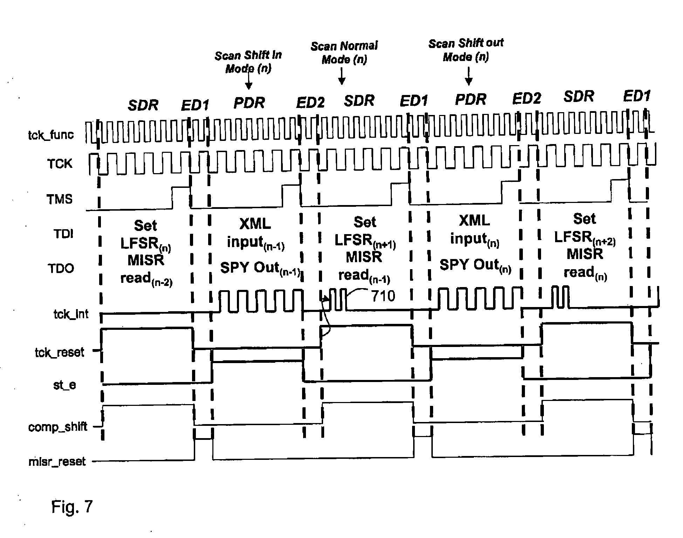

As shown in Fig. 6, the test module may be extended with a functional clock control block (CCB) 610 for generating a two-pulse signal for subjecting the functional block 110 to an 'at-speed' test for determining whether or not the functional block comprises signal paths exhibiting excessive delay behaviour. Such a clock control block is known per se; an example of such a clock control block is disclosed in PCT patent application with application number IB2007/050025. The TAP controller 155 is further arranged to generate a CCB_reset signal on signal line 620 to reset the clock control block 610. In case of the presence of the clock control block 610, the delay test may be invoked in response to a further dedicated instruction shifted into the instruction register 150. Table Ill gives an overview of the signals generated in the different states of the TAP controller 155 in response to the further dedicated instruction, whereas Fig. 7 gives an overview of the state of the various signals relevant to the operation of the test module as a function of time.

**Table III INSTRUCTION SIP_COMP_DELAY**

| TAP CNTRL STATES | TAP RESET | 142 | 146 | TCK release | CCB reset | tck_int release | 144 |
|---|---|---|---|---|---|---|---|
| TLR | 1 | 0 | 0 | 1 | 1 | 1 | 0 |
| RTI | 0 | 0 | 0 | 1 | 1 | 1 | 0 |
| SDS | 0 | 0 | 0 | 1 | 1 | 1 | 0 |
| CDR | 0 | 0 | 0 | 1 | 1 | 1 | 0 |
| SDR | 0 | 1 | 0 | 1 | 0 | 1* | 0 |
| E1D | 0 | 0 | 1 | 0 | 1 | 0 | 0 |
| PDR | 0 | 0 | 0 | 1 | 1 | 1 | 1 |
| E2D | 0 | 0 | 0 | 0* | 1 | 0* | 0 |
| UDR | 0 | 0 | 0 | 1 | 1 | 1 | 0 |
| SIS | 0 | 0 | 0 | 1 | 1 | 1 | 0 |
| CIR | 0 | 0 | 0 | 1 | 1 | 1 | 0 |
| SIR | 0 | 0 | 0 | 1 | 1 | 1 | 0 |
| E11 | 0 | 0 | 0 | 1 | 1 | 1 | 0 |
| PIR | 0 | 0 | 0 | 1 | 1 | 1 | 0 |
| E21 | 0 | 0 | 0 | 1 | 1 | 1 | 0 |
| UIR | 0 | 0 | 0 | 1 | 1 | 1 | 0 |

The differences in generated signals between the instruction SIP_TEST and SIP _COMP_DELAY are highlighted in Table III with an (*). In state SDR, the functional clock is enabled to facilitate the generation of a train of clock pulses 710 by the clock control block 610 in response to the rising edge of a reset signal tck_reset generated by the TAP controller 150 on signal line 620 in this state. The train of clock pulses typically comprises a limited number of clock pulses, e.g. two pulses, and is generated with a delay to the rising edge of the reset signal. This purpose of this train of pulses is explained in more detail in the aforementioned patent application in which the clock control block 610 has been described. In this test mode, the functional block 110 is tested at functional speed. For this reason, the internal functional clock tck_func of the functional block 110 is released in the E2D state of the TAP controller 155 instead of the internal test clock tck_int.

The IC die 100 may be tested using an ATE suitable for communicating with a TAP 140. Such an ATE typically comprises a test clock signal generator for providing TCK of TAP 140 with a test clock signal, a test mode signal generator for providing TMS of TAP 140 with the test mode select signal and an input for receiving data from TDO of TAP 140. In accordance with the present invention, the ATE is configured to communicate the dedicated instruction for activating the test module of the functional block 110 to TDI of memory. The ATE is further configured to communicate the compressed test pattern to TDI, e.g. a seed for a LFSR. This compressed test pattern may be generated on the fly or retrieved from an internal memory of the ATE. In case the test module comprises masking logic 125, the ATE may also be configured to communicate the mask information to TDI. It will be appreciated that the communication of the various data via TDI and TDO will be compliant with the control mechanism for the test module as previously described. To this end, the ATE may be loaded with a software module that governs the compliance with this control mechanism. The software module may include the dedicated instruction, the compressed test patterns and the masking information, and may be generated by an automated test pattern generation (ATPG) tool.

It should be noted that the above-mentioned embodiments illustrate rather than limit the invention, and that those skilled in the art will be able to design many alternative embodiments without departing from the scope of the appended claims. In the claims, any reference signs placed between parentheses shall not be construed as limiting the claim. The word "comprising" does not exclude the presence of elements or steps other than those listed in a claim. The word "a" or "an" preceding an element does not exclude the presence of a plurality of such elements. The invention can be implemented by means of hardware comprising several distinct elements. In the device claim enumerating several means, several of these means can be embodied by one and the same item of hardware. The mere fact that certain measures are recited in mutually different dependent claims does not indicate that a combination of these measures cannot be used to an advantage.

## Claims

1. An integrated circuit die (100) comprising:
a functional block (110) having a plurality of inputs and a plurality of outputs;
a test module for testing the functional block (110) in a test mode, the test module comprising:
test pattern decompression logic (120) comprising a clock signal input, an input for receiving a compressed test pattern and a plurality of outputs for providing the plurality of inputs of the functional block (110) with the decompressed test pattern; and
test result compression logic (130) comprising a clock signal input, a plurality of inputs for receiving a test result from the plurality of outputs of the functional block (110) and an output for making the test result available in a compressed form;
the integrated circuit die further comprising a test access port (140) comprising:
a test data input (TDI) coupled to the test pattern decompression logic input;
a test data output (TDO) coupled to the test result compression logic output;
a test clock input (TCK) coupled to the respective clock inputs of the test pattern decompression logic (120) and the test result compression logic (130);
a test mode select input (TMS) for receiving a test mode select signal; and i
an instruction register (150) coupled between the test data input (TDI) and the test module for activating the test module in response to a dedicated instruction received from the test data input (TDI).

2. An integrated circuit die (100) as claimed in claim 1, wherein the test access port (140) comprises a test access port controller (155) configured to step through a number of states in response to the test mode select signal, the test access port controller (155) being configured to:
enable data communication between the test data input (TDI) and the input of the test pattern decompression logic (120) and enable data communication between the output of the test result compression logic (130) and the test data output (TDO) in a first state (SHIFT_DR); and
enable data communication between the test module and the functional block (110) in a second state (EXIT2_DR).

3. An integrated circuit die (100) as claimed in claim 2, wherein the test access port controller (155) is configured to reset the test result compression logic (130) in a third state (EXITI_DR).

4. An integrated circuit die (100) as claimed in claim 1, 2 or 3, wherein the test module further comprises masking logic (125) coupled between the functional block (110) and the test result compression logic (130), the masking logic (130) having an input coupled to the test data input (TDI) for receiving masking configuration data, the test access port controller (155) being configured to enable data communication between the test data input (TDI) and the input of the masking logic (125) in a fourth state (PAUSE_DR).

5. An integrated circuit die (100) as claimed in any of claims 1-4, further comprising:
first clock gating logic for gating the test clock signal to the test pattern decompression logic (120); and
second clock gating logic for gating the test clock signal to the test result compression logic (130).

6. An integrated circuit die (100) as claimed in any of claims 1-5, further comprising:
a first multiplexer (160) having an output and a plurality of inputs, each coupled to a respective output from the plurality of outputs (165) of the functional block (110) such that the test result compression logic (130) is bypassed; and
a second multiplexer (170) having a first input coupled to the output of the test result compression logic (130), a second input coupled to the output of the first multiplexer (160) and an output coupled to the test data output (TDO).

7. An integrated circuit as claimed in any of claims 1-6, wherein the test module comprises a clock control block (610) for controlling a functional clock of the functional block (110), the test access port controller (155) being arranged to generate a reset signal for the clock control block (610), the clock control block (610) being configured to generate a pulse train (710) having a limited number of pulses in response to the reset signal for facilitating a delay test of the functional block (110).

8. An integrated circuit package comprising an integrated circuit die (100) as claimed in any of claims 1-7, wherein the test data input (TDI), the test data output (TDO), the test mode select input (TMS) and the test clock input (TCK) are externally accessible.

9. An integrated circuit package as claimed in claim 8, wherein the package comprises a plurality of integrated circuit dies.

10. Automated test equipment for testing an integrated circuit die (100) as claimed in any of claims 1-9, comprising:
means for communicating data to the test data input (TDI), said means being configured to:
- communicate the dedicated instruction for activating the test module; and
- communicate a compressed test pattern for the test pattern decompression logic (120);
clock signal generation means for providing the test clock input (TCK) with the test clock signal;
test mode selection means for providing the test mode select input (TMS) with the test mode select signal; and
data reception means for receiving data from the test data output (TDO).
